(19) Europäisches Patentamt
European Patent Office
Office européen des brevets

(11) **EP 4 468 538 A1**

(12) **EUROPEAN PATENT APPLICATION**

(43) Date of publication:
**27.11.2024 Bulletin 2024/48**

(21) Application number: **24150059.4**

(22) Date of filing: **02.01.2024**

(51) International Patent Classification (IPC):
*H01S 5/023* (2021.01)     *H01S 5/02345* (2021.01)
*H01S 5/0234* (2021.01)     *H01S 5/0237* (2021.01)
*H01S 5/024* (2006.01)

(52) Cooperative Patent Classification (CPC):
**H01S 5/02469; H01S 5/023; H01S 5/0234;
H01S 5/02345; H01S 5/0237;** H01S 5/02234

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.05.2023 TW 112119209**

(71) Applicant: **Wistron Corporation
New Taipei City 22181 (TW)**

(72) Inventors:
• **LIN, Huang-Yu
22181 New Taipei City (TW)**
• **LI, Heng
22181 New Taipei City (TW)**
• **PAN, Hung-Chun
22181 New Taipei City (TW)**

(74) Representative: **Viering, Jentschura & Partner
mbB
Patent- und Rechtsanwälte
Am Brauhaus 8
01099 Dresden (DE)**

(54) **OPTICAL TRANSCEIVER SYSTEM AND LASER DIODE DEVICE THEREOF**

(57) An optical transceiver system (2) includes a laser diode device (1b). The laser diode device (1b) includes a first submount (11), a second submount (12), a laser diode (10), and a bump (14). The first submount (11) includes a first electrode (116). The second submount (12) corresponds to the first submount (11) and includes a second electrode (128). The laser diode (10) is between the first submount (11) and the second submount (12), and a side of the laser diode (10) adjacent to the first submount (11) is electrically connected to the first electrode (116). The laser diode (10) has a waveguide (102) and the waveguide (102) is on a side of the laser diode (10) away from the first submount (11). The bump (14) corresponds to the waveguide (102), one of two ends of the bump (14) is electrically connected to the second electrode (128), and a height (H1) of the bump (14) is substantially higher than a height (H2) of the waveguide (102).

FIG. 3A

EP 4 468 538 A1

## Description

## BACKGROUND

### Technical Field

The instant disclosure relates to an optical transceiver system and a laser diode device thereof, particularly a laser diode device having a waveguide and an optical transceiver system comprising the laser diode device.

### Related Art

Along with the increasingly improved speed of communication, demands for laser diodes with their luminous efficacy being suitable for applying to high-speed optical communication products are also increased. Compared with existing laser diodes applied to low-speed optical communication products, power of laser diodes applied to high-speed optical communication products is relatively higher, and the heat generated by the laser diodes is also increased. Moreover, on certain demands, some laser diodes have to be driven at a relatively lower temperature.

### SUMMARY

In view of this, according to some embodiments, a laser diode device is provided, and the laser diode device comprises a first submount, a second submount, a laser diode, and a bump. The first submount comprises a first electrode. The second submount corresponds to the first submount and the second submount comprises a second electrode. The laser diode is between the first submount and the second submount, and a side of the laser diode adjacent to the first submount is electrically connected to the first electrode. The laser diode has a waveguide and the waveguide is on a side of the laser diode away from the first submount. The bump corresponds to the waveguide and one of two ends of the bump is electrically connected to the second electrode, wherein a height of the bump is substantially higher than a height of the waveguide.

According to some embodiments, the other end of the bump is electrically connected to the laser diode to allow the bump to be electrically connected to the first electrode through the side of the laser diode adjacent to the first submount.

According to some embodiments, the bump is a stud bump, the stud bump has a first diameter at a side of the stud bump adjacent to the laser diode, the stud bump has a second diameter at a side of the stud bump adjacent to the second submount, and a ratio of the first diameter over the second diameter is between 0.9 and 1.1.

According to some embodiments, the bump is a stud bump, the stud bump has a first diameter at a side of the stud bump adjacent to the laser diode, the stud bump has the height extending from the laser diode toward the second submount, and a ratio of the first diameter over the height of the stud bump is between 0.85 and 1.1.

According to some embodiments, a receiving space is between the first submount, the laser diode, and the second submount. The receiving space is filled with a filling material, wherein the filling material comprises an insulating base and a plurality of conductive particles, the conductive particles are distributed over the insulating base, and parts of the conductive particles are between the bump and the second submount.

According to some embodiments, the bump is a second submount protrusion, and the second submount protrusion extends from the second submount to allow the laser diode to be electrically connected to the second electrode through the second submount protrusion.

According to some embodiments, the bump is a conductive paste on a side of the laser diode adjacent to the second submount.

In addition, according to some embodiments, an optical transceiver system is further provided, and the optical transceiver system comprises an optical fiber, a lens, and the laser diode device. The lens is adjacent to the optical fiber. The laser diode of the laser diode device is communicatively connected to the lens and the optical fiber through a light source.

According to some embodiments, the optical transceiver system further comprises a laser diode driver electrically connected to the laser diode device, wherein the laser diode driver emits a driving signal to the laser diode device to allow the laser diode of the laser diode device to be communicatively connected to the lens and the optical fiber through the light source.

### BRIEF DESCRIPTION OF THE DRAWINGS

FIG. 1A illustrates a schematic perspective view of an uncovered laser diode device according to some embodiments;

FIG. 1B illustrates a schematic cross-sectional view along the line A-A' of the uncovered laser diode device shown in FIG. 1A;

FIG. 2A illustrates a schematic perspective view of a covered laser diode device in a first view according to some embodiments;

FIG. 2B illustrates a schematic perspective view of the covered laser diode device shown in FIG. 2A in a second view;

FIG. 3A illustrates a schematic cross-sectional view along the line B-B' of the covered laser diode devices shown in FIG. 2A and FIG. 2B;

FIG. 3B illustrates a schematic cross-sectional view along the line C-C' of the covered laser diode device shown in FIG. 3A;

FIG. 4 illustrates an enlarged partial perspective view of the laser diode shown in FIG. 3A;

FIG. 5 illustrates a simulated surface temperature profile of an uncovered laser diode device and a covered laser diode device (having the stud bumps) according to some embodiments;

FIG. 6A illustrates a simulated surface temperature profile of a covered laser diode device (having one or more of the stud bumps) according to some embodiments;

FIG. 6B illustrates a simulated surface temperature profile of the covered laser diode device (having one or more of the stud bumps) shown in FIG. 6A;

FIG. 7 illustrates a schematic cross-sectional view along the line C-C' as shown in FIG. 3A of the covered laser diode device according to some embodiments;

FIG. 8 illustrates a schematic cross-sectional view along the line C-C' as shown in FIG. 3A of the covered laser diode device according to some embodiments;

FIG. 9 illustrates a schematic cross-sectional view along the line C-C' as shown in FIG. 3A of the covered laser diode device according to some embodiments;

FIG. 10 illustrates a schematic cross-sectional view along the line C-C' as shown in FIG. 3A of the covered laser diode device according to some embodiments;

FIG. 11 illustrates a schematic cross-sectional view along the line C-C' as shown in FIG. 3A of the covered laser diode device according to some embodiments; and

FIG. 12 illustrates a schematic block diagram of an optical transceiver system according to some embodiments.

## DETAILED DESCRIPTION

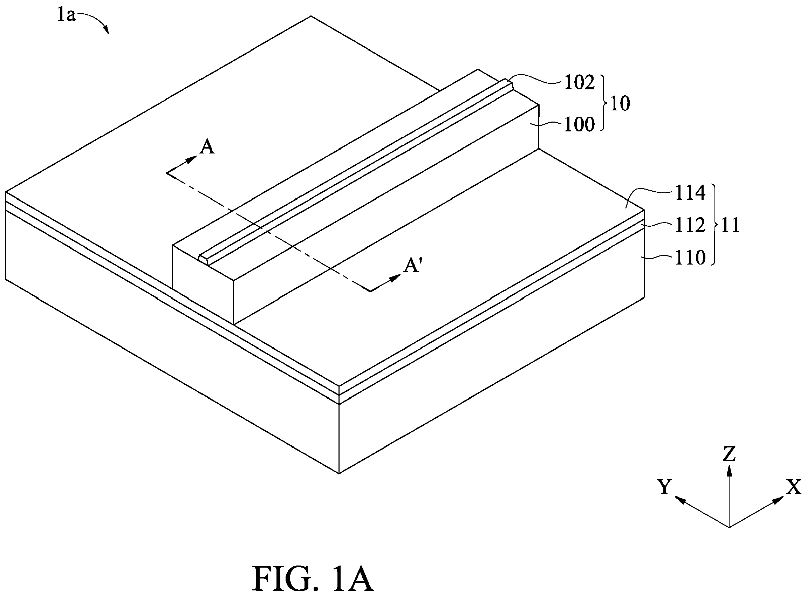

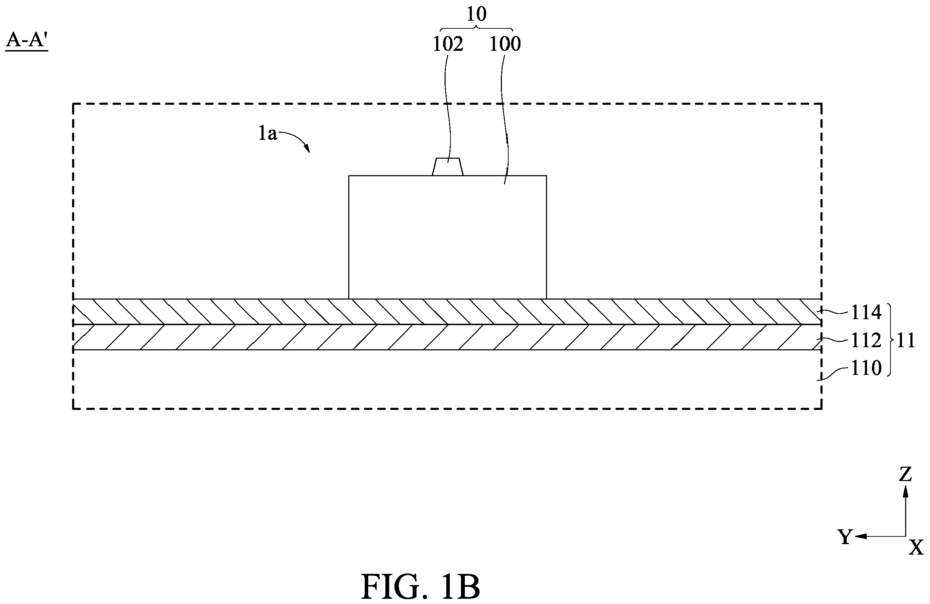

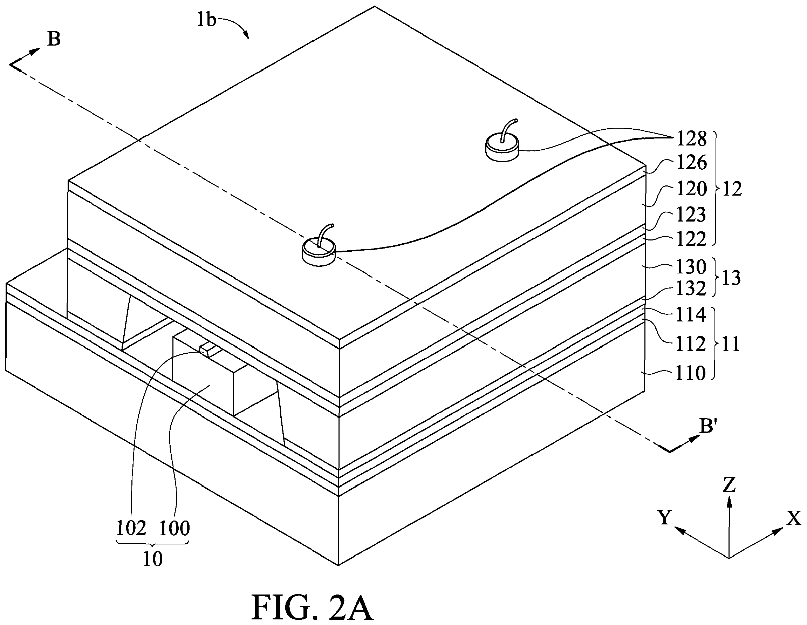

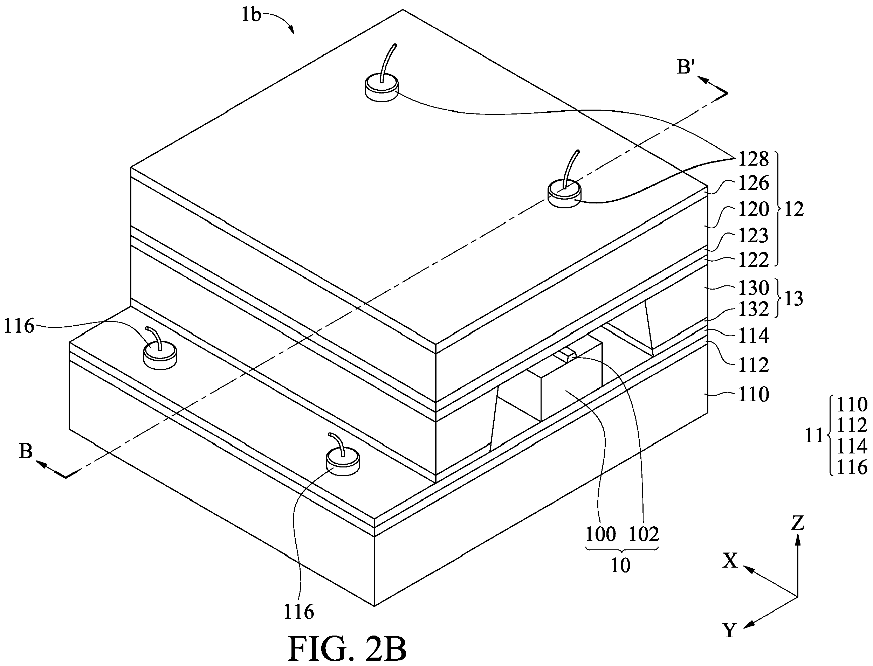

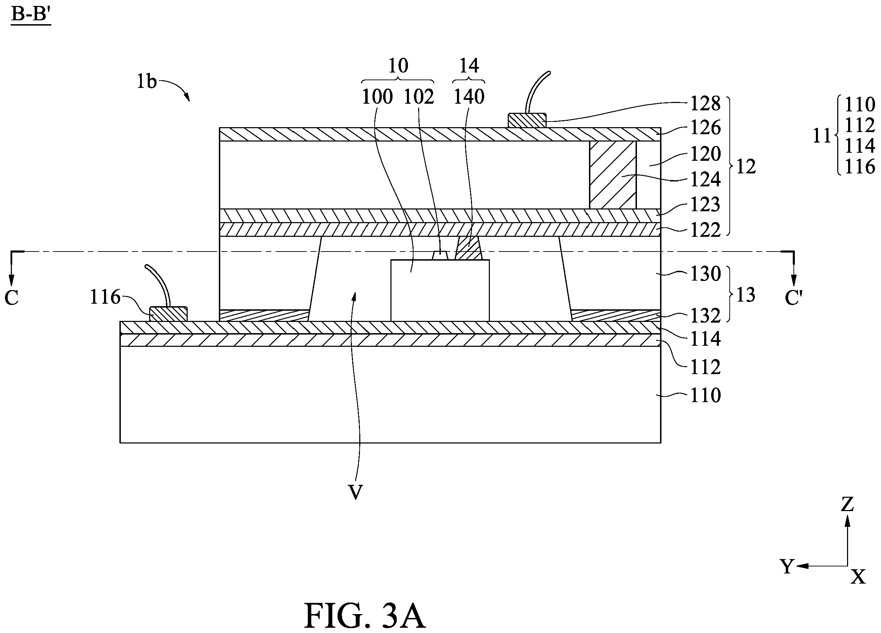

Please refer to FIG. 1A, FIG. 1B, FIG. 2A, and FIG. 2B. FIG. 1A illustrates a schematic perspective view of an uncovered laser diode device 1a according to some embodiments; FIG. 1B illustrates a schematic cross-sectional view along the line A-A' of the uncovered laser diode device 1a shown in FIG. 1A; FIG. 2A illustrates a schematic perspective view of a covered laser diode device 1b in a first view according to some embodiments; and FIG. 2B illustrates a schematic perspective view of the covered laser diode device 1b shown in FIG. 2A in a second view. To more clearly illustrate the embodiments, the uncovered laser diode devices 1a shown in FIG. 1A and FIG. 1B are basically identical to the covered laser diode device 1b shown in FIG. 2A and FIG. 2B, and the difference between the uncovered laser diode device 1a and the covered laser diode device 1b is that, in FIG. 1A and FIG. 1B, only a first submount 11 and a laser diode 10 of the laser diode device 1a are illustrated (which will be referred to as the "uncovered" laser diode device 1a herein); while in FIG. 2A and FIG. 2B, in addition to the first submount 11 and the laser diode 10, a second submount 12 and a bump 14 (the bump 14 may be referred to in FIG. 3A, which will be described later) of the laser diode device 1b are further illustrated (which will be referred to as the "covered" laser diode device 1b herein). It is noted that if not particularly annotated by the term "uncovered," the term "laser diode device 1b" used herein indicates "the covered laser diode device 1b."

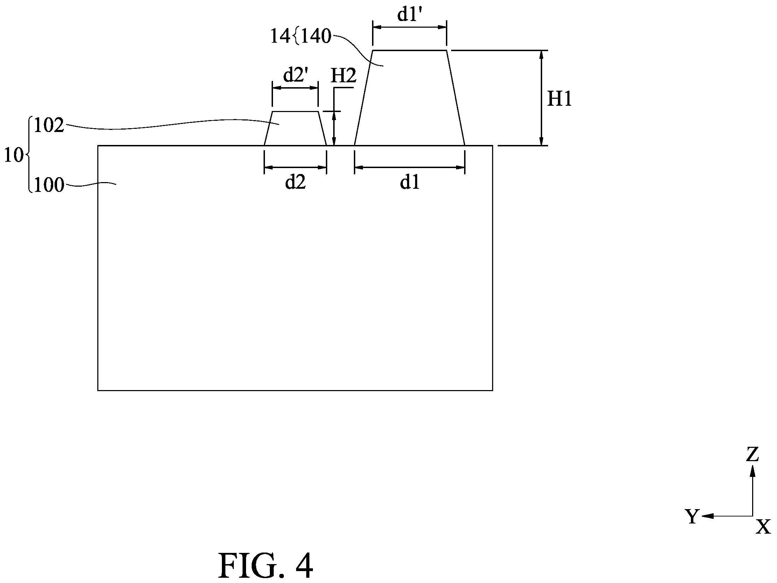

In FIG. 1A, FIG. 1B, FIG. 2A, and FIG. 2B, the laser diode device 1b comprises a first submount 11, a second submount 12 (shown in FIG. 2A and FIG. 2B), a laser diode 10, and a bump 14. The first submount 11 comprises a first electrode 116 (shown in FIG. 2B, which may be a ball of wire bonding). The second submount 12 corresponds to the first submount 11 and the second submount 12 comprises a second electrode 128 (shown in FIG. 2A and FIG. 2B, which may be a ball of wire bonding). The laser diode 10 is between the first submount 11 and the second submount 12 (shown in FIG. 2A and FIG. 2B), and a side of the laser diode 10 adjacent to the first submount 11 is electrically connected to the first electrode 116. The laser diode 10 has a waveguide 102 on the laser diode 10 (e.g., on a side of the laser diode 10 away from the first submount 11). The waveguide 102 may be an optical waveguide to guide visible light and/or other electromagnetic waves (which will be described later). The bump 14 corresponds to the waveguide 102 (e.g., the bump 14 is adjacent to the waveguide 102 and on a side of the laser diode 10 away from the first submount 11). One of two ends of the bump 14 is electrically connected to the second electrode 128 (which will be described later). A height H1 of the bump 14 is substantially higher than a height H2 of the waveguide 102 (shown in FIG. 3A and FIG. 4, which will be described later). The material of the bump 14 may be an electrically and/or thermally conductive material to allow the surface heat generated by the laser diode 10 (e.g., the surface heat on the side of the laser diode 10 adjacent to the waveguide 102) to be guided away from the laser diode 10, thereby rapidly reducing the surface temperature of the laser diode 10. Meanwhile, the bump 14 may be electrically connected to the second electrode 128 to receive the current from the second electrode 128 and guide the current to the laser diode 10, so that the laser diode 10 may be further driven by the current. Moreover, through the arrangement that the height H1 of the bump 14 is substantially higher than the height H2 of the waveguide 102, the waveguide 102 can be prevented from being directly contacted and further damaged by the second submount 12. Hence, in some embodiments, the waveguide 102 can be effectively prevented from being damaged by the cover of the second submount 12 (and/or being squeezed by the second submount 12 cause by the thermal expansion of the second submount 12) which will further affect the luminous efficacy of the waveguide 102, so that the surface cooling performance of the laser diode 10 can be enhanced effectively at the same time.

In some embodiments, the laser diode 10 may be any laser diode having the structure of the waveguide 102; for example, the laser diode 10 may be but not limited to a distributed feedback (DFB) laser, an electro-absorption modulated laser (EML), a Fabry-Perot (FP) laser, a distributed Bragg reflector (DBR), a quantum dot (QD) laser, or any combination thereof. In other words, the laser diode 10 may be at least one selected from the group consisting of a distributed feedback (DFB) laser, an electro-absorption modulated laser (EML), a Fabry-Perot (FP) laser, a distributed Bragg reflector (DBR), and a quantum dot (QD) laser. Therefore, the laser diode 10 also comprises a combination of two or even more than two selected from the above group. Hence, through the laser diode 10 having the characteristics of high output power and fast modulation speed, the laser diode device 1b can be applied to the high-speed optical communication, such as medium-distance and long-distance high-speed broadband telecommunications transmission.

Please refer to FIG. 1B and FIG. 3A. FIG. 3A illustrates a schematic cross-sectional view along the line B-B' of the covered laser diode devices 1b shown in FIG. 2A and FIG. 2B. In FIG. 1B and FIG. 3A, the laser diode 10 has a laser diode chip 100, and the laser diode chip 100 has two opposite sides (e.g., a side on the +Z direction and a side on the -Z direction shown in FIG. 3A) with opposite conductivity types. For example, a side of the laser diode chip 100 adjacent to the first submount 11 is an n-type layer, a side of the laser diode chip 100 away from the first submount 11 is a p-type layer, and a p-n junction layer (or called active layer) is between the n-type layer and the p-type layer. When a forward current is introduced to the laser diode chip 100, the electrons and the electron holes in the p-n junction layer will thus recombine and generate photons with the corresponding energy. The materials of the n-type layer, the p-type layer, and the p-n junction may be any combination of materials that can be arbitrarily matched with each other and still function normally, which is not limited herein.

In FIG. 3A, a side of the laser diode 10 adjacent to the first submount 11 (e.g., an n-type layer) is electrically connected to the first electrode 116; in the meantime, a side of the laser diode 10 away from the first submount 11 (e.g., a p-type layer) is electrically connected to the second electrode 128. Hence, through the forward current introduced from the first electrode 116 (or the second electrode 128) to the laser diode chip 100, the p-n junction layer will thus generate photons with the corresponding energy. The materials of the first electrode 116 and the second electrode 128 may be any combination of materials that can be arbitrarily matched with each other and still function normally, which is not limited herein. The numbers, shapes, and locations of the first electrode 116 and the second electrode 128 may be arranged according to various demands, which are not limited herein. For example, take FIG. 2A and FIG. 2B as an example, each of the first electrode 116 and the second electrode 128 comprises two electrodes along the +X direction, and any one of the first electrodes 116 and a corresponding one of the second electrodes 128 can be arranged on the same YZ plane.

According to some embodiments, the first submount 11 comprises a first submount body 110, a first connection layer 114, and a first electrode 116 (shown in FIG. 3A). The laser diode 10 is electrically connected to the first electrode 116 through the first connection layer 114. For example, in FIG. 1B and FIG. 3A, the first connection layer 114 is between the first submount body 110 and the laser diode 10 (shown in FIG. 3A), a first end of the first connection layer 114 is electrically connected to the laser diode 10, and a second end of the first connection layer 114 is electrically connected to the first electrode 116. Hence, when the first electrode 116 is an n-type electrode, the first connection layer 114 may be used to guide the current of the laser diode 10 away from the laser diode 10 as far as possible. For example, the first connection layer 114 extends along the +Y direction shown in FIG. 3A to guide the current of the laser diode 10 to the first electrode 116 outside the second submount 12 (e.g., the exterior of the receiving space V shown in FIG. 3A, which will be described later), and vice versa. The material of the first submount body 110 may be glass, plastic, rubber, ceramic, or a combination comprising two or more selected from the group consisting of glass, plastic, rubber, and ceramic; for example, the material of the first submount body 110 may be but not limited to ceramic heat dissipation material. Specifically, in some embodiments, the material of the first submount body 110 may be, for example, aluminum nitride (AlN), silicon, sapphire, or III-V semiconductor materials. The material of the first connection layer 114 may be any electrically conductive material, which may be but not limited to gold, tin, or gold-tin alloy. The material of the first electrode 116 may be any electrically conductive material, which may be but not limited to metal or alloy. Through electrically connecting an external device to the first electrode 116 outside the second submount 12, the external device can be electrically connected to the laser diode 10 inside the second submount 12 rapidly; moreover, an electrically conductive channel (e.g., a via) on the second submount 12 is not further needed for the electrical connection between the first electrode 116 and the external device, and thus the time and cost for the manufacturing process can be reduced.

In some embodiments, the first submount 11 further comprises a first top plate 112. The first top plate 112 is between the laser diode 10 and the first submount body 110, and the first top plate 112 is electrically connected to the first connection layer 114. For example, in FIG. 3A, the first top plate 112 is between the first connection layer 114 and the first submount body 110. For another example, the first top plate 112 is between the first connection layer 114 and the laser diode 10. Hence, the laser diode 10 can be electrically connected to the first connection layer 114 through the first top plate 112. The material of the first top plate 112 may be any electrically conductive material, which may be but not limited to gold, tin, or gold-tin alloy.

According to some embodiments, the second submount 12 comprises a second submount body 120, a second connection layer 122, a via 124, and a second electrode 128. The laser diode 10 is electrically connected to the second electrode 128 through the second connection layer 122. For example, in FIG. 2A, FIG. 2B, and FIG. 3A, the second connection layer 122 is on a side of the second submount body 120 adjacent to the laser diode 10. The via 124 is penetratingly in the second submount body 120. The second connection layer 122 and the second electrode 128 that are respectively on the two opposite sides (i.e., the two ends of the via 124) are electrically connected to each other through the via 124. For example, a first side of the second connection layer 122 is electrically connected to the laser diode 10 (e.g., through the bump 14, which will be described later), and a second side of the second connection layer 122 is electrically connected to a first end of the via 124, and a second end of the via 124 is electrically connected to the second electrode 128. Therefore, when the second electrode 128 is a p-type electrode, the second connection layer 122 may be used to guide the current that is far away and dispersed to the laser diode 10 as close as possible. For example, the second connection layer 122 extends along an extending direction (e.g., the +Y direction shown in FIG. 3A) that is substantially different from the extending direction of the first connection layer 114 (e.g., the -Y direction shown in FIG. 3A), so that the current can be guided from the second electrode 128 outside the second submount 12 (e.g., the exterior of the receiving space V shown in FIG. 3A) to the laser diode 10, and vice versa. The material of the second submount body 120 may be metal, alloy, plastic, rubber, ceramic, or a combination comprising two or more selected from the group consisting of metal, alloy, plastic, rubber, and ceramic; for example, the material of the second submount body 120 may be but not limited to ceramic heat dissipation material. Specifically, in some embodiments, the material of the second submount body 120 may be, for example, AlN, aluminum oxide ($Al_2O_3$), silicon carbide

(SiC), aluminum, copper, iron, or stainless steel. The material of the second connection layer 122 may be any electrically conductive material, which may be but not limited to gold, tin, or gold-tin alloy. The material of the second electrode 128 may be any electrically conductive material, which may be but not limited to metal or alloy. Accordingly, through electrically connecting an external device to the second electrode 128 outside the second submount 12, the external device can be electrically connected to the laser diode 10 inside the second submount 12 rapidly.

In some embodiments, the via 124 is filled with a filling material, and the filling material may be but not limited to metal or alloy, such as tungsten. Therefore, the second connection layer 122 and the second electrode 128 that are respectively on the two opposite sides (i.e., the two ends of the via 124) may be electrically connected to each other through the via 124. The number, shape, and location of the via 124 may be arranged according to various demands, which are not limited herein. For example, any two of the via 124 may be grouped and arranged (that is, a pair of the via 124); for example, at least one group of the via 124 (i.e., two of the via 124) can be arranged sequentially along the +X direction shown in FIG. 2B. In some embodiments, the location of the via 124 may be adjusted according to the arrangement of the second electrode 128; for example, the via 124 is adjacent to the second electrode 128 while the second electrode 128 is not needed to be directly on the corresponding via 124. Hence, in some embodiments, through the via 124 that can be arranged in any shape and on any location of the second submount body 120, not only a denser and more sophisticated wiring but also a more effectively enhanced cooling performance of the laser diode 10 can be provided.

In some embodiments, the second submount 12 further comprises a second top plate 123. The second top plate 123 is on a side of the second connection layer 122 away from the laser diode 10, and the second top plate 123 is electrically connected to the second connection layer 122. Hence, the second connection layer 122 can be electrically connected to the second electrode 128 through the second top plate 123. For example, in FIG. 3A, the second top plate 123 is between the second connection layer 122 and the second electrode 128. For another example, the second top plate 123 is between the second connection layer 122 and the laser diode 10. For example, the second top plate 123 is on a side of the second connection layer 122 adjacent to the laser diode 10, and the second top plate 123 is electrically connected to the second connection layer 122. Hence, the laser diode 10 can be electrically connected to the second connection layer 122 through the second top plate 123. The material of the second top plate 123 may be any electrically conductive material, which may be but not limited to gold, tin, or gold-tin alloy.

According to some embodiments, the second submount 12 further comprises a third top plate 126. The third top plate 126 is between the via 124 and the second electrode 128, and the third top plate 126 is electrically connected to the via 124 to allow the via 124 and the second electrode 128 to be electrically connected to each other through the third top plate 126. For example, in FIG. 3A, the third top plate 126 is between the second submount body 120 and the second electrode 128. The material of the third top plate 126 may be any electrically conductive material, which may be but not limited to gold, tin, or gold-tin alloy.

Please refer to FIG. 3A. According to some embodiments, the laser diode device 1b further comprises one or more side walls 13. The side wall(s) 13 is between the first submount 11 and the second submount 12 to form a receiving space V among the first submount 11, the laser diode 10, the second submount 12, and the side wall(s) 13. In FIG. 3A, the laser diode device 1b further comprises two side walls 13 respectively on two sides of the laser diode 10, and each of the side walls 13 comprises a sidewall body 130 and a sidewall connection layer 132. Each of the sidewall bodies 130 is between the first submount 11 and the second submount 12. One of two ends of each of the sidewall bodies 130 is connected to (e.g., by welding or bonding) the first submount 11 through the sidewall connection layer 132, and the other end of the each of the sidewall bodies 130 is connected to the second submount 12. The stacked height (along the Z direction shown in FIG. 3A) of each of the sidewall bodies 130 (which are respectively on two sides of the second submount 12) and the corresponding one of the sidewall connection layers 132 is substantially identical to the stacked height (along the Z direction) of the laser diode 10 and the corresponding bump 14. The material of the sidewall body 130 may be glass, metal, alloy, plastic, rubber, ceramic, or a combination comprising two or more selected from the group consisting of glass, metal, alloy, plastic, rubber, and ceramic; for example, the material of the sidewall body 130 may be but not limited to ceramic heat dissipation material. Specifically, in some embodiments, the material of the sidewall body 130 may be, for example, AlN, $Al_2O_3$, SiC, aluminum, copper, iron, or stainless steel. The material of the sidewall connection layer 132 may be any electrically conductive material, which may be but not limited to gold, tin, or gold-tin alloy. Therefore, in some embodiments, through the side wall(s) 13, the receiving space V with a sufficient height can be provided by the laser diode device 1b, so that the waveguide 102 can be prevented from being damaged caused by the direct contact between the waveguide 102 and the second submount 12 (and/or the waveguide 102 can be prevented from being squeezed caused by the thermal expansion of the second submount 12). In some embodiments, the side wall(s) 13 and the second submount 12 are integrally formed as a one-piece member, so that the connection between the side wall(s) 13 and the second submount 12 can be enhanced.

In some embodiments, through the first submount 11 and the second submount 12, double heat flows (DHFs) may be formed on two opposite sides of the laser diode 10 (i.e., a side of the laser diode 10 adjacent to the first submount 11 and a side of the laser diode 10 adjacent to the second submount 12), so that a parallel-like circuit (with a lower overall resistance) is thus formed to be further electrically connected to the junction element(s) (not illustrated) at the two sides of the laser diode 10. Since the existing laser diode device (e.g., the uncovered laser diode device 1a shown in FIG. 1A) only has, for example, the first submount 11 and does not covered by the second submount 12 and the second connection layer 122, the junction element(s) is electrically connected to the upper side of the laser diode 10 directly and thus only a single heat flow (SHF) is formed. Therefore, a series-like circuit (with a higher overall resistance) would be formed by two opposite sides of the existing laser diode 10. Hence, in some embodiments, compared with the existing uncovered laser diode device 1a, the laser diode device 1b can have the characteristics of a lower overall resistance and a less generated heat.

According to some embodiments, the laser diode 10 is electrically connected to the second electrode 128 through the bump 14. For example, in FIG. 3A, one of two ends of the bump 14 (e.g., an end of the bump 14 adjacent to the laser diode 10) is electrically connected to the laser diode 10, and the other end of the bump 14 (e.g., an end of the bump 14 away from the laser diode 10) is electrically connected to the second connection layer 122 and further electrically connected to the second electrode 128 through the via 124.

In FIG. 3A, the bump 14 is adjacent to the waveguide 102 and on the laser diode 10. For example, a distance (along the +Y direction shown in FIG. 3A) between the bump 14 and the waveguide 102 may be at least 4 $\mu$m, and a distance between the bump 14 and the edge of the laser diode chip 100 may be at least 5 $\mu$m, so that the operation of the waveguide 102 and/or the laser diode chip 100 can be prevented from being affected. The material of the waveguide 102 may be but not limited to any material that can be used as a photoresist, such as silicon, silicon dioxide, indium phosphide (InP), gallium arsenide (GaAs), or a combination comprising two or more selected from the group consisting of silicon, silicon dioxide, indium phosphide (InP), and gallium arsenide (GaAs). The shape of the waveguide 102 may be but not limited to a strip waveguide (e.g., a rectangular waveguide or a ridge waveguide) or a rib waveguide.

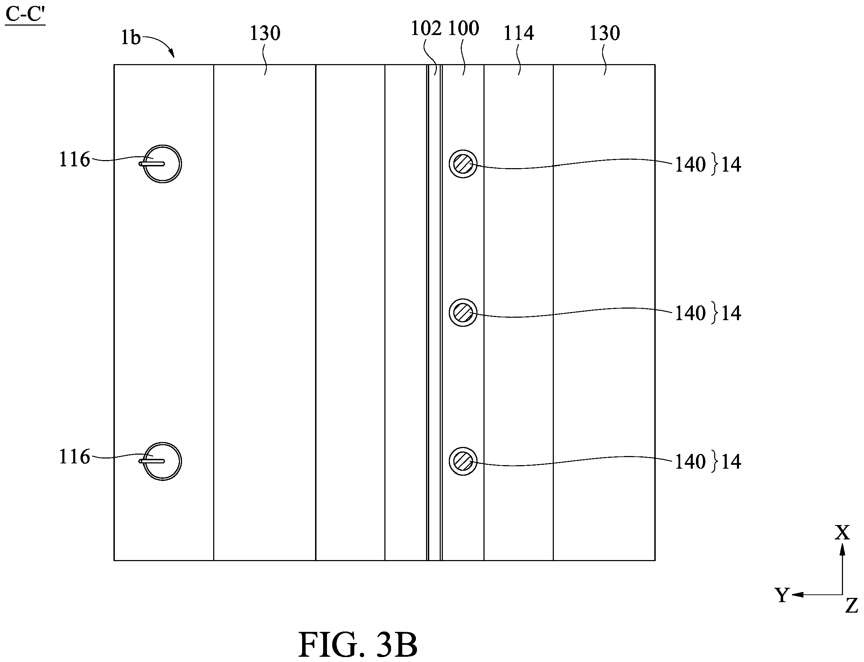

Please refer to FIG. 3A, FIG. 3B, and FIG. 4. FIG. 3B illustrates a schematic cross-sectional view along the line C-C' of the covered laser diode device 1b shown in FIG. 3A; and FIG. 4 illustrates an enlarged partial perspective view of the laser diode 10 shown in FIG. 3A. In the schematic cross-sectional views of FIG. 3A and FIG. 4, the waveguide 102 has a height H2 extending from the laser diode 10 toward the second submount 12 (e.g., the +Z direction shown in FIG. 3A). The waveguide 102 has a bottom width d2 (along the +Y direction) on a side of the waveguide 102 adjacent to the laser diode 10, and the waveguide 102 has a top width d2' (along the +Y direction) on a side of the waveguide 102 away from the laser diode 10. The top width d2' of the waveguide 102 may be substantially identical to or different from the bottom width d2 of the waveguide 102. For example, when the top width d2' is less than or greater than the bottom width d2, the waveguide 102 may be a ridge waveguide; for an alternative example, when the top width d2' is substantially equal to the bottom width d2, the waveguide 102 may be a rectangular waveguide. In the top view shown in FIG. 3B, the waveguide 102 may be on the laser diode 10 (i.e., on the laser diode chip 100) and extend along the +X direction, so that a strip waveguide extending along +X direction may be formed.

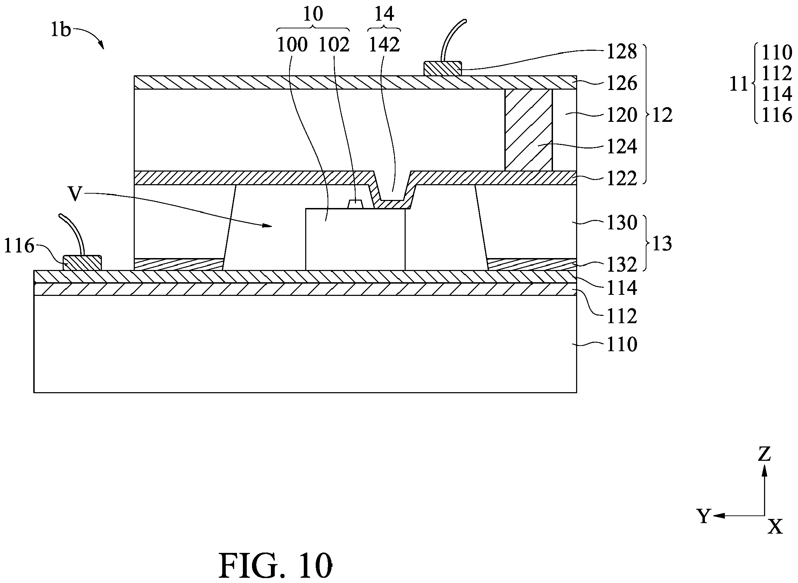

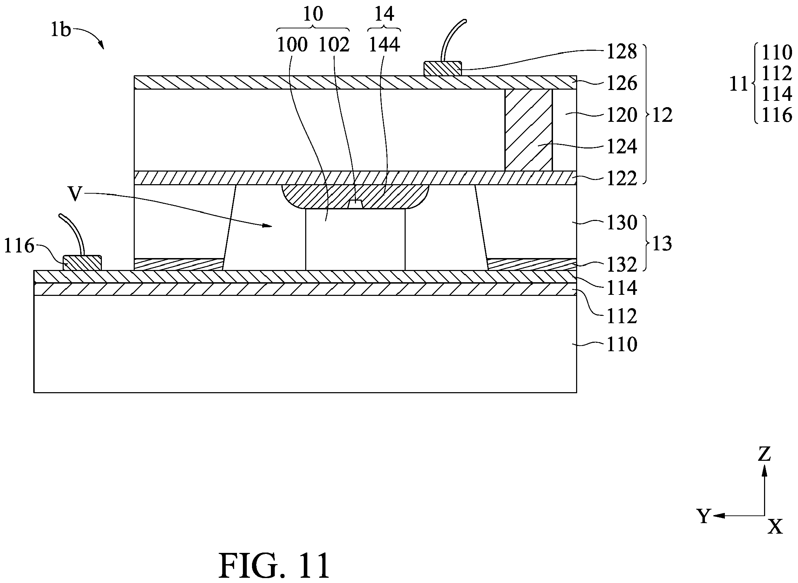

The bump 14 may be but not limited to a stud bump 140 (shown in FIG. 3A and FIG. 3B, which will be described later), a second submount protrusion 142 (shown in FIG. 10, which will be described later), a conductive paste 144 (shown in FIG. 11, which will be described later), or a combination comprising two or more selected from the group consisting of the stud bump 140, the second submount protrusion 142, and the conductive paste 144. The material of the bump 14 may be any electrically conductive and/or thermally conductive material.

In some embodiments, the bump 14 is a stud bump 140. The material of the stud bump 140 may be but not limited to gold, copper, silver, tin, or gold-tin alloy. Please refer to FIG. 3A and FIG. 4. The stud bump 140 has a height H1 extending from the laser diode 10 toward the second submount 12 (e.g., the +Z direction shown in FIG. 3A), and the height H1 of the stud bump 140 is substantially higher than the height H2 of the waveguide 102. For example, the height H1 of the stud bump 140 is between about 50 $\mu$m and about 60 $\mu$m, and the height H2 of the waveguide 102 is between about 1 $\mu$m and about 3 $\mu$m (e.g., about 2 $\mu$m). The stud bump 140 has a bottom width (i.e., a first diameter d1; along the +Y direction) on a side of the stud bump 140 adjacent to the laser diode 10, and the stud bump 140 has a top width (i.e., a second diameter d1'; along the +Y direction) on a side of the stud bump 140 away from the laser diode 10. The first diameter d1 may be substantially identical to or different from the second diameter d1'; for example, a ratio of the first diameter d1 over the second diameter d1' is between 0.9 and 1.1; that is, a relationship between the first diameter d1 and the second diameter d1' complies with the following Eq. (1).

$$0.9 \leq \frac{d1}{d1'} \leq 1.1 \qquad \text{Eq. (1)}$$

In FIG. 3B, the geometric arrangement of the stud bump 140 along the X direction may be substantially identical to or different from the geometric arrangement of the stud bump 140 along the Y direction. For example, in FIG. 3B, the stud bump 140 also has a bottom width (along the X direction) on a side of the stud bump 140 adjacent to the laser diode 10, and the stud bump 140 has a top width (along the X direction) on a side of the stud bump 140 away from the laser diode 10. The bottom width and the top width along the X direction are substantially identical to the bottom width (i.e., the first diameter d1) and the top width (i.e., the second diameter d1') along the Y direction, and thus a cylindrical stud bump 140 may be formed. The cylindrical stud bump 140 may be manufactured on the laser diode 10 (i.e., the laser diode chip 100) by wire bonding. In some embodiments, the first diameter d1 of the cylindrical stud bump 140 may be substantially identical to or different from the height H1 of the stud bump 140. For example, a ratio of the first diameter d1 of the cylindrical stud bump 140 over the height H1 of the stud bump 140 is between 0.85 and 1.1; that is, a relationship between the first diameter d1 and the height H1 of the stud bump 140 complies with the following Eq. (2). For example, the first diameter d1 of the cylindrical stud bump 140 is between about 50 $\mu$m and about 60 $\mu$m, and the height H1 of the stud bump 140 is between about 50 $\mu$m and about 60 $\mu$m. For another example, the first diameter d1 of the cylindrical stud bump 140 may be between about 50 $\mu$m and about 60 $\mu$m, the height H1 of the stud bump 140 may be about 58 $\mu$m, and thus the ratio of the first diameter d1 of the stud bump 140 over the height H1 may be, for example, between 0.86 and 1.03.

$$0.85 \leq \frac{d1}{H1} \leq 1.1 \qquad \text{Eq. (2)}$$

In some embodiments, the bump 14 may be one or more stud bumps 140. Each of the stud bumps 140 is adjacent to the waveguide 102 and distributed over a side of the laser diode 10 adjacent to the second submount 12. In other words, the number of the stud bump(s) 140 may be one or more; for example, the number of the stud bump(s) 140 may be at least one, between 1 and 18, at least three, between 3 and 18, between 3 and 15, between 3 and 12, between 3 and 9, or between 3 and 6. For example, in FIG. 3B, the number of the bumps 14 are three and these bumps 14 are adjacent to the waveguide 102 and sequentially arranged along the X direction. In some embodiments, a ratio of a sum of the bottom area of the stud bump(s) 140 (which is denoted as A1 herein) over a surface area of the laser diode 10 (i.e., the laser diode chip 100) (which is denoted as A2 herein) is between 0.02 and 0.30. In other words, a relationship between the sum A1 of the bottom area of the stud bump(s) 140 and the surface area A2 of the laser diode 10 complies with the following Eq. (3). For example, the first diameter d1 of the bumps 140 may be between about 50 $\mu$m and about 60 $\mu$m, the number of the stud bumps 140 may be between 3 and 18, the length and the width of the laser diode 10 are respectively 1,000 $\mu$m

and 200 μm, and thus the sum A1 of the bottom area of the stud bumps 140 over the surface area A2 of the laser diode 10 may be, for example, between 0.0294 and 0.254.

$$0.02 \leq \frac{A1}{A2} \leq 0.30 \qquad \text{Eq. (3)}$$

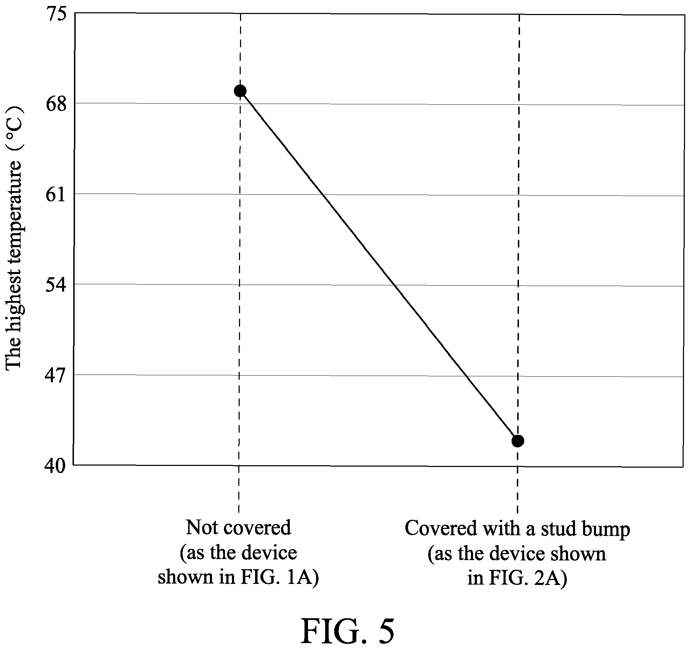

Please refer to FIG. 1A, FIG. 2A, and FIG. 5 at the same time. FIG. 5 illustrates a simulated surface temperature profile of an uncovered laser diode device 1a and a covered laser diode device 1b (having the stud bumps 140) according to some embodiments. In FIG. 5, the uncovered laser diode device 1a can be referred to the uncovered laser diode device 1a shown in FIG. 1A, while the covered laser diode device 1b (having three stud bumps 140), which is briefly referred to as "the covered laser diode device 1b", can be referred to the laser diode device 1b shown in FIG. 2A (or FIG. 2B). Each of the uncovered laser diode device 1a and the covered laser diode device 1b is applied with a power of 477 mW, so that each of the uncovered laser diode device 1a and the covered laser diode device 1b can be used as a heat source that can be sufficiently dissipated to reach a thermal equilibrium with the environment. The highest surface temperatures of the uncovered laser diode device 1a and the covered laser diode device 1b then can be obtained by simulation, and as shown in FIG. 5, the highest surface temperatures of the uncovered laser diode device 1a and the covered laser diode device 1b are respectively about 70 °C and about 50 °C. In other words, as compared to the uncovered laser diode device 1a, the covered laser diode device 1b (having the stud bumps 140) can have a temperature reduction of 28.6%. Accordingly, through the cover (e.g., the second submount 12) and the stud bump(s) 140, the laser diode device 1b can indeed enhance the surface cooling performance of the laser diode 10 effectively, thereby greatly reducing the surface temperature of the laser diode 10.

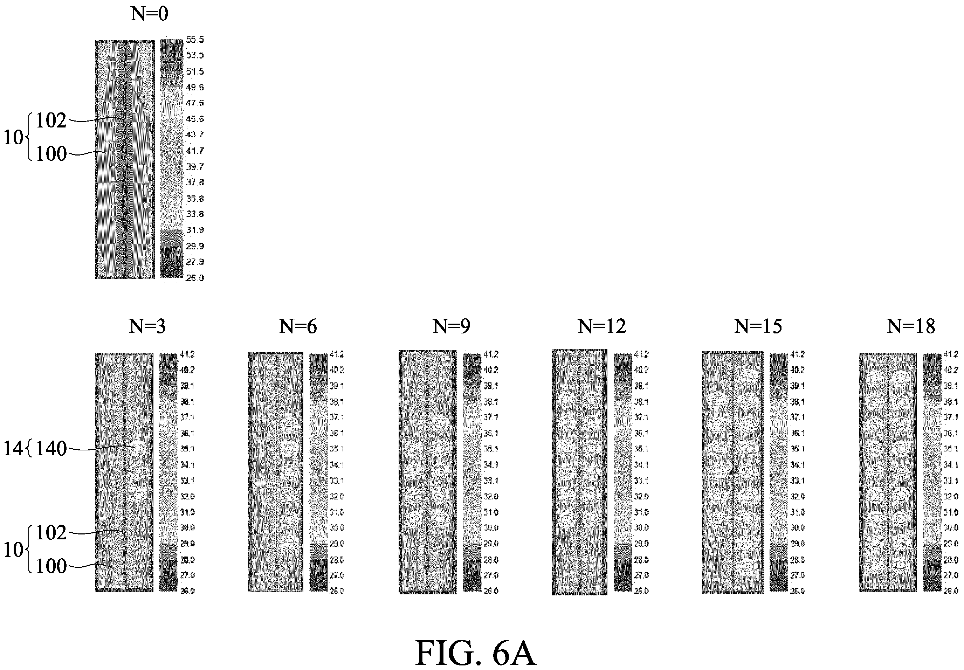

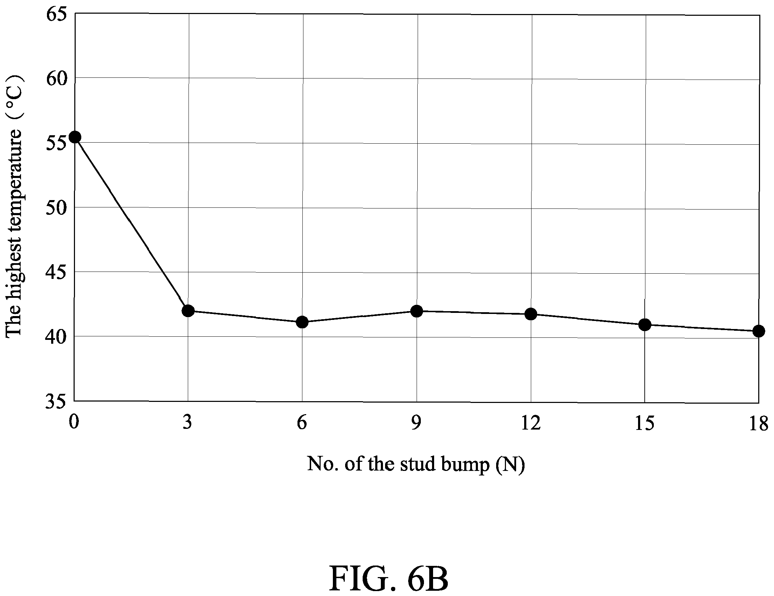

Please refer to FIG. 6A and FIG. 6B. FIG. 6A illustrates a simulated surface temperature profile of a covered laser diode device 1b (having one or more of the stud bumps 140) according to some embodiments; and FIG. 6B illustrates a simulated surface temperature profile of the covered laser diode device 1b (having one or more of the stud bumps 140) shown in FIG. 6A. The experimental methods and conditions applied in FIG. 6A and FIG. 6B are the same as those of FIG. 5, and will not be described in detail herein. In FIG. 6A, the simulated surface temperature profiles of the laser diode chips 100 having the waveguide 102 and the stud bumps 140 are illustrated, and the numbers (which is represented by "N") of the stud bumps 140 of each of the laser diode chips 100 are 0, 3, 6, 9, 12, 15, and 18, respectively. From the result of the surface temperature profiles shown in FIG. 6A, when the laser diode chip 100 is not equipped with the stud bump 140 (i.e., N=0), the surface temperatures of a quite large region of the laser diode chip 100 adjacent to the waveguide 102 is greater than about 49.6 °C, while the surface temperatures of another large region is between about 47.6 °C and about 49.6 °C, and only the four corners of the laser diode chip 100 respectively have a lower temperature which is between about 45.6 °C and about 47.6 °C. That is, if the laser diode chip 100 is not equipped with the stud bump 140 (i.e., N=0), the difference between the surface temperature on the laser diode 10 and the temperature of the waveguide 102 is merely about 7 °C. In other words, the surface temperature of the laser diode chip 100 that is not equipped with the stud bump 140 (i.e., N=0) cannot be reduced effectively, thereby leading to an apparently poorer cooling performance. In contrast, when the laser diode chip 100 is further equipped with the stud bumps 140 (whichever N=3, 6, 9, 12, 15, or 18), the surface temperature of a quite small region of the laser diode chip 100 adjacent to the waveguide 102 is greater than about 41.2 °C, while the surface temperatures of the rest regions of the laser diode chip 100 are all between about 30.9 °C and about 36.1 °C. Hence, the overall surface temperature profiles of the laser diode chips 100 having the stud bumps 140 are apparently more uniformed, and the overall surface temperature of the laser diode chips 100 can be indeed reduced greatly and effectively. In other words, the surface temperature of the laser diode chip 100 (and the profiles thereof) are basically not affected by varying the number N of the stud bumps 140 at least in a certain range of N (e.g., 0<N≤18). Furthermore, once the laser diode chip 100 is equipped with the stud bump(s) 140, the surface cooling performance of the laser diode 10 can be enhanced effectively, and the heat on the surface of the laser diode 10 can be also prevented from being accumulated at a certain area of the surface of the laser diode 10.

Further, according to the highest surface temperatures of the laser diode chips 100 shown in FIG. 6B (which correspond to the laser diode chips 100 shown in FIG. 6A), when the laser diode chip 100 is not equipped with the stud bump 140 (i.e., N=0), the highest surface temperature of the laser diode chip 100 is about 55 °C; in contrast, when the laser diode chip 100 is further equipped with the stud bumps 140 (whichever N=3, 6, 9, 12, 15, or 18), the highest surface temperatures of the laser diode chips 100 are between about 40 °C and about 43 °C. Therefore, the highest surface temperatures of the laser diode chips 100 having the stud bumps 140 can be indeed reduced greatly and effectively. In other words, the highest surface temperature of the laser diode chip 100 are basically not affected by varying the number N of the stud bumps 140 at least in a certain range of N (e.g., 0<N≤18). Furthermore, once the laser diode chip 100 is equipped with the stud bump(s) 140, the surface cooling performance of the laser diode 10 can be enhanced effectively, thereby greatly reducing the surface temperature of the laser diode 10.

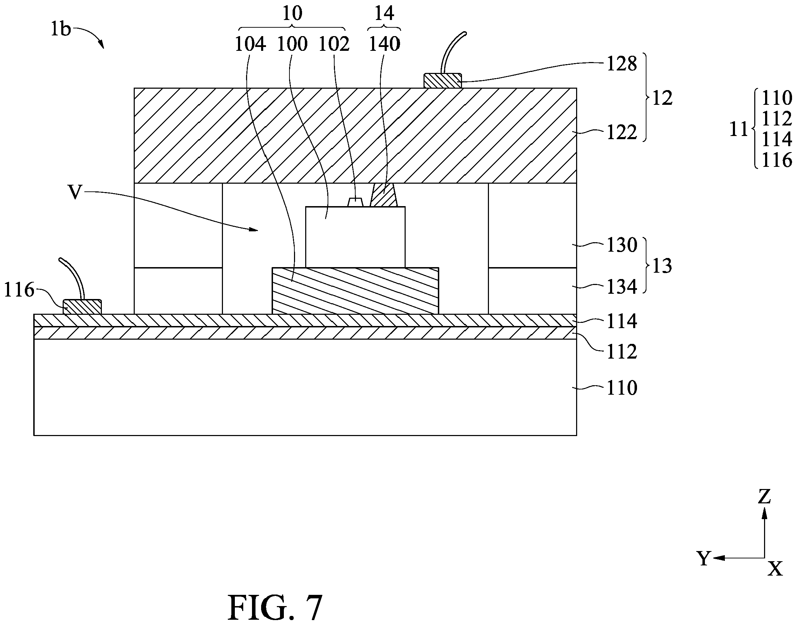

Please refer to FIG. 7. FIG. 7 illustrates a schematic cross-sectional view along the line C-C' as shown in FIG. 3A of the covered laser diode device 1b according to some embodiments. For example, in FIG. 7, the second submount 12 comprises the second connection layer 122 and the second electrode 128 (which may optionally not include the second submount body 120, the via 124, and the third top plate 126). Two ends of the second connection layer 122 are respectively on the side walls 13. The second electrode 128 is on the second connection layer 122, and the laser diode 10 is electrically connected to the second electrode 128 through the second connection layer 122.

In FIG. 7, the side walls 13 of the laser diode device 1b are the two side walls 13 respectively on the two sides of the laser diode 10, and each of the side walls 13 comprises a sidewall body 130 and one or more sidewall interposer layers 134. Each of the sidewall bodies 130 is between the first submount 11 and the second submount 12. One of two ends of each of the sidewall bodies 130 is connected to the first submount 11 through the sidewall interposer layer(s) 134, and the other end of each of the sidewall bodies 130 is connected to the second submount 12. Through the stacking of one or more sidewall interposer layers 134, the height of each of the side walls 13 may be further adjusted, so that the stacked height (along the Z direction shown in FIG. 7) of the sidewall bodies 130 at the two sides of the second submount 12 and the corresponding sidewall interposer layer(s) 134 may be substantially identical to the stacked height (along the Z direction shown in FIG. 7) of the laser diode 10 and the corresponding bumps 14. The material of the sidewall interposer layer 134 and the material of the sidewall body 130 may be substantially identical to or matched with each other, which may independently be glass, metal, alloy, plastic, rubber, ceramic, or a combination comprising two or more selected from the group consisting of glass, metal, alloy, plastic, rubber, and ceramic; for example, the material of the sidewall interposer layers 134 and/or the sidewall bodies 130 may be but not limited to ceramic heat dissipation material. Specifically, in some embodiments, the material of the sidewall interposer layers 134 and/or the sidewall bodies 130 may be, for example, AlN, $Al_2O_3$, SiC, aluminum, copper, iron, or stainless steel. The term "matched" refers to the physical and/or chemical properties of two materials are not greatly different from each other; for example, the coefficients of thermal expansion of the two materials are close to each other. Therefore, through the sidewall body 130 (and the sidewall interposer layer(s) 134 of the sidewall body 130), the receiving space V with a sufficient height can be provided by the laser diode device 1b, so that the waveguide 102 can be prevented from being damaged caused by the direct contact between the waveguide 102 and the second submount 12 (and/or the waveguide 102 can be prevented from being squeezed caused by the thermal expansion of the second submount 12).

In FIG. 7, the laser diode 10 further comprises one or more chip interposer layers 104, and the chip interposer layer(s) 104 is between the laser diode chip 100 and the first submount 11. Through the stacking of one or more chip interposer layers 104, the height of the laser diode chip 100 and the bump(s) 14 in the receiving space V may be further adjusted, so that the stacked height (along the Z direction shown in FIG. 7) of the sidewall bodies 130 at the two sides of the second submount 12 may be substantially identical to the stacked height (along the Z direction shown in FIG. 7) of the laser diode 10 and the corresponding bumps 14. The material of the chip interposer layer(s) 104 may be glass, metal, alloy, plastic, rubber, ceramic, or a combination comprising two or more selected from the group consisting of glass, metal, alloy, plastic, rubber, and ceramic; for example, the material of the chip interposer layer(s) 104 may be but not limited to ceramic heat dissipation material. Specifically, in some embodiments, the material of the chip interposer layer(s) 104 may be, for example, AlN, $Al_2O_3$, SiC, aluminum, copper, iron, or stainless steel. Therefore, through the chip interposer layer(s) 104, the receiving space V with a sufficient height can be provided by the laser diode device 1b, so that the bumps 14 can be electrically connected to the second submount 12 (i.e., the second submount body 120) more properly.

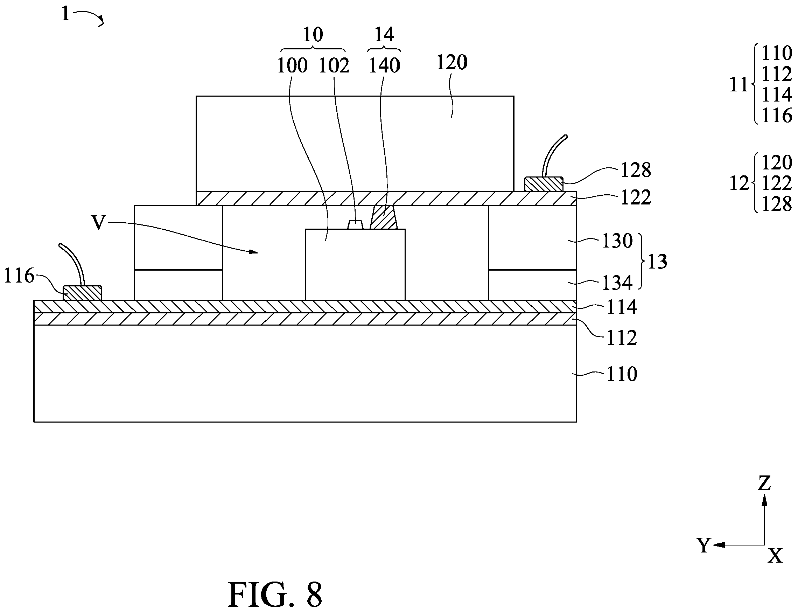

Please refer to FIG. 8. FIG. 8 illustrates a schematic cross-sectional view along the line C-C' as shown in FIG. 3A of the covered laser diode device 1b according to some embodiments. For example, in FIG. 8, the second submount 12 comprises the second submount body 120, the second connection layer 122, and the second electrode 128 (which may optionally not include the via 124 and the third top plate 126). Two ends of the second connection layer 122 are respectively on the side walls 13. The second submount body 120 is on the second connection layer 122. The second connection layer 122 may, for example, extend along the -Y direction shown in FIG. 8 to expose parts of the second connection layer 122, and the second electrode 128 is on the exposed parts of the second connection layer 122. The laser diode 10 is electrically connected to the second electrode 128 through the second connection layer 122, so that the current can be guided from the second electrode 128 outside the second submount 12 (e.g., the exterior of the receiving space V shown in FIG. 8) to the laser diode 10, and vice versa.

In FIG. 8, the side walls 13 of the laser diode device 1b are the two side walls 13 respectively on the two sides of the laser diode 10, and each of the side walls 13 comprises a sidewall body 130 and one or more sidewall interposer layers 134. Each of the sidewall bodies 130 is between the first submount 11 and the second submount 12. One of two ends of each of the sidewall bodies 130 is connected to the first submount 11 through the sidewall interposer layer(s) 134, and the other end of each of the sidewall bodies 130 is connected to the second submount 12. The arrangement embodiments of the sidewall body 130 and the sidewall interposer layer 134 may be referred to the aforementioned embodiments, and will not be described in detail herein.

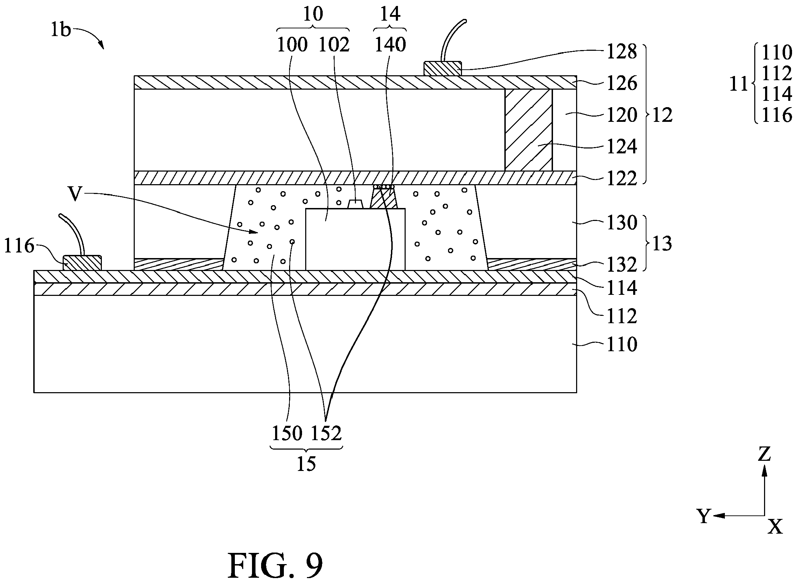

Please refer to FIG. 9. FIG. 9 illustrates a schematic cross-sectional view along the line C-C' as shown in FIG. 3A of the covered laser diode device 1b according to some embodiments. The arrangement embodiments of the laser diode device 1b shown in FIG. 9 can be referred to the aforementioned embodiments, and will not be described in detail herein. The major difference between FIG. 9 and the aforementioned embodiments is that, in FIG. 9, a portion of or all of the receiving space V is filled with a filling material 15. For example, at least between the bump 14 (e.g., the stud bump 140) and the second submount 12 in the receiving space V is filled with the filling material 15. The filling material 15 comprises an insulating base 150 and a plurality of conductive particles 152. The conductive particles 152 are distributed over the insulating base 150, and parts of the conductive particles 152 are between the bump 14 and the second submount 12. The filling material 15 may be any anisotropic conductive material, such as (but not limited to) an anisotropic conductive paste (ACP) or an anisotropic conductive film (ACF). When a pressure is applied to the conductive particles 152 between the bump 14 and the second submount 12, the conductive particles 152 subjected to the applied pressure will be fused and combined with each other, thereby forming at least one conductive channel. The bump 14 and the second submount 12 will thus be electrically connected to each other through the conductive channel. Meanwhile, because the insulating base 150 is still filled between those conductive particles 152 that are not subjected to the applied pressure, those conductive particles 152 will not be conducted with each other. Therefore, even though the conductive channel has been formed between the bump 14 and the second submount 12, the receiving space V filled with the filling material 15 still cannot be shirt-circuited. Hence, through the bump 14 and the filling material 15, the electric connection between the bump 14 and the second submount 12 can be further enhanced, so that the thermal energy on the surface of the laser diode 10 can be reduced effectively. Moreover, the insulating base 150 of the filling material 15 can be also used as an underfill, and thus moisture can be prevented from entering the laser diode 10, thereby enhancing the service life of the laser diode 10.

Please refer to FIG. 10. FIG. 10 illustrates a schematic cross-sectional view along the line C-C' as shown in FIG. 3A of the covered laser diode device 1b according to some embodiments. The arrangement embodiments of the laser diode device 1b shown in FIG. 10 can be referred to the aforementioned embodiments, and will not be described in detail herein. The major difference between FIG. 10 and the aforementioned embodiments is that, in FIG. 10, the bump 14 is the second submount protrusion 142. The second submount protrusion 142 extends from the second submount 12 (i.e., the second submount body 120) to allow the second electrode 128 and the laser diode 10 to be electrically connected to each other through the second submount protrusion 142. A side of the second submount protrusion 142 adjacent to the second submount 12 (i.e., the second submount body 120) has a top width, and a side of the second submount protrusion 142 away from the second submount 12 (i.e., the second submount body 120) has a bottom width. The top width of the second submount protrusion 142 may be substantially identical to or different from the bottom width of the second submount protrusion 142. For example, in FIG. 10, the top width of the second submount protrusion 142 is greater than the bottom width of the second submount protrusion 142, so that a second substrate protrusion 142 is formed as an inverted ridge structure having a wide top and a narrow bottom. The second substrate protrusion 142 with the inverted ridge structure (having a wide top and a narrow bottom) can be more suitable for the manufacturing of the second submount 12 and the second submount protrusion 142. For example, the second submount protrusion 142 and the second submount body 120 may be integrally formed as a one-piece member, so that the complicated manufacturing process can be reduced and the connection between the second submount protrusion 142 and the second submount body 120 can be enhanced, thereby providing the second submount 12 and the second submount protrusion 142 with a more stable quality. The material of the second submount protrusion 142 and the material of the second submount body 120 may be substantially identical to or matched with each other, which may independently be metal, alloy, plastic, rubber, ceramic, or a combination comprising two or more selected from the group consisting of metal, alloy, plastic, rubber, and ceramic; for example, the material of the second submount protrusion 142 and/or the second submount body 120 may be but not limited to ceramic heat dissipation material. Specifically, in some embodiments, the material of the second submount protrusion 142 and/or the second submount body 120 may be, for example, AlN, $Al_2O_3$, SiC, aluminum, copper, iron, or stainless steel. The term "matched" refers to the physical and/or chemical properties of two materials are not greatly different from each other; for example, the coefficients of thermal expansion of the two materials are close to each other. In some embodiments, the second submount 12 further comprises the second connection layer 122. The second connection layer 122 is between the second submount protrusion 142 and the laser diode 10 to allow the laser diode 10 and the second electrode 128 (including the second submount body 120 and the second submount protrusion 142) to be electrically connected to each other through the second connection layer 122. The arrangement embodiments of the second connection layer 122 can be referred to the aforementioned embodiments, and will not be described in detail herein.

Please refer to FIG. 11. FIG. 11 illustrates a schematic cross-sectional view along the line C-C' as shown in FIG. 3A of the covered laser diode device 1b according to some embodiments. The arrangement embodiments of the laser diode device 1b shown in FIG. 11 can be referred to the aforementioned embodiments, and will not be described in detail herein. The major difference between FIG. 11 and the aforementioned embodiments is that, in FIG. 11, the bump 14 is the conductive paste 144. The conductive paste 144 is on a side of the laser diode 10 adjacent to the second submount 12 to allow the laser diode 10 and the second submount 12 (i.e., the second electrode 128) to be electrically connected to each other through the conductive paste 144. The material of the conductive paste 144 may be but not limited to silver, tin, copper, gold, carbon, or alloy comprising two or more selected from the group consisting of silver, tin, copper, gold, and carbon, and for example, a silver paste, a copper paste, a gold paste, a carbon paste, a tin ball, or a combination comprising two or more selected from the group consisting of a silver paste, a copper paste, a gold paste, and a carbon paste may be thus formed. Since the conductive paste 144 is in a fluid state during the manufacturing process, the conductive paste 144 in the fluid state not only can be directly arranged on the laser diode chip 100, but also can be directly arranged on the waveguide 102. Furthermore, since the cured conductive paste 144 can have appearance and shape that are substantially conformal to the appearances and shapes of the laser diode chip 100 and the waveguide 102, not only a superior electrical connection can be established between the laser diode 10 and the second submount 12, damage and/or squeeze of the waveguide 102 caused by the cured conductive paste 144 can be also avoided. Through the conductive paste 144, the laser diode 10 and the second submount 12 (i.e., the second electrode 128) can be electrically connected to each other through a larger connection area, so that the overall resistance can be reduced more effectively, thereby generating a less thermal energy. Moreover, owing to the fluidic characteristic of the conductive paste 144 during the manufacturing process, the conductive paste 144 can be directly arranged on the laser diode chip 100 without intentionally avoiding the waveguide 102, thereby greatly reducing the time and cost for the manufacturing process of the laser diode device 1b as compared with the time and cost for the existing manufacturing process.

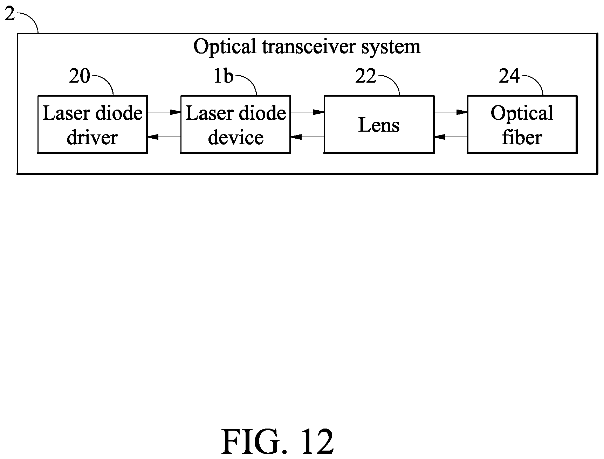

Please refer to FIG. 12. FIG. 12 illustrates a schematic block diagram of an optical transceiver system 2 according to some embodiments. In FIG. 12, an optical transceiver system 2 is provided, wherein the optical transceiver system 2 comprises an optical fiber 24, a lens 22, and a laser diode device 1b. The optical fiber 24 is adapted to transmit a light source (or an optical signal), such as adapted to emit a light source (or an optical signal) and/or receive a light source (or an optical signal). The lens 22 is adjacent to the optical fiber 24 to receive and/or emit the light source (or the optical signal). The arrangement embodiments of the laser diode device 1b can be referred to the aforementioned embodiments, and will not be described in detail herein. The laser diode 10 may be configured to be communicatively connected to the lens 22 and the optical fiber 24 through the light source. For example, the laser diode driver 20 is adapted to receive the light source (or the optical signal) from the lens 22 or emit the light source (or the optical signal) to the lens 22 and the optical fiber 24. For example, when the optical fiber 24 is configured to emit a light source (or an optical signal), the lens 22 is thus configured to receive the light source (or the optical signal) from the optical fiber 24 to further emit the light source (or the optical signal) to the laser diode device 1b; or for another example, when the optical fiber 24 is configured to receive a light source (or an optical signal), the lens 22 is thus configured to receive the light source (or the optical signal) from the laser diode device 1b to further emit the light source (or the optical signal) to the optical fiber 24. In some embodiments, through the laser diode 10 that is communicatively connected to those light sources (i.e., receiving those light sources from the optical fiber 24 and/or emitting those light sources to the optical fiber 24), the optical transceiver system 2 can be used as an optical subassembly (OSA) for high-speed signal transmission, such as a transmitter optical subassembly (TOSA), a receiver optical subassembly (ROSA), or a combination of TOSA and ROSA.

In FIG. 12, according to some embodiments, the optical transceiver system 2 which is used as an optical subassembly (OSA) for high-speed signal transmission may be combined with an electrical subassembly (ESA) to be driven by the ESA so as to be further combined and used as a light-transmitting module for high-speed signal transmission. The ESA may be, for example, a laser diode driver 20. For example, in FIG. 12, the optical transceiver system 2 further comprises a laser diode driver 20. The laser diode driver 20 is electrically connected to the laser diode device 1b, and the laser diode driver 20 emits a driving signal (e.g., a differential voltage signal or a current driving signal) to the laser diode device 1b to allow the laser diode 10 of the laser diode device 1b to be communicatively connected to the lens 22 and the optical fiber 24 through the light source. For example, the laser diode 10 of the laser diode device 1b is adapted to receive the light source (or the optical signal) from the lens 22 or emit the light source (or the optical signal) to the lens 22 and the optical fiber 24. Hence, through the laser diode device 1b having a superior cooling performance, the optical transceiver system 2 can thus have much broader and more diverse applications without being limited by the shortcomings of the poorer cooling performance encountered by the existing device.

To sum up, in some embodiments, through a bump, a first electrode, and a second electrode, a laser diode (and the first electrode) and the second electrode that are respectively on two sides of the bump can be electrically connected to each other and thus double heat flows (DHFs) may be formed, so that an overall resistance of a parallel-like circuit may be further formed.

Therefore, in some embodiments, an optical transceiver system (and the laser diode device of the optical transceiver system) can provide with a much lower overall resistance as compared with those of the existing devices and thus with a much less generated thermal energy, thereby enhancing the surface cooling performance of the laser diode effectively at the same time. Furthermore, in some embodiments, through a height of the bump that is substantially higher than a height of the waveguide, the waveguide of the optical transceiver system (and the laser diode device of the optical transceiver system) can be prevented from being damaged caused by the cover of a second submount (and/or being squeezed by the second submount caused by the thermal expansion of the second submount).

**Claims**

1. A laser diode device (1b) comprising:

    a first submount (11) comprising a first electrode (116);
    a second submount (12) corresponding to the first submount (11) and comprising a second electrode (128);
    a laser diode (10) between the first submount (11) and the second submount (12), wherein a side of the laser diode (10) adjacent to the first submount (11) is electrically connected to the first electrode (116), and the laser diode (10) has a waveguide (102) on a side of the laser diode (10) away from the first submount (11); and
    a bump (14) corresponding to the waveguide (102), wherein one of two ends of the bump (14) is electrically connected to the second electrode (128), and a height (H1) of the bump (14) is substantially higher than a height (H2) of the waveguide (102).

2. The laser diode device (1b) according to claim 1, wherein the other end of the bump (14) is electrically connected to the laser diode (10) to allow the bump (14) to be electrically connected to the first electrode (116) through the side of the laser diode (10) adjacent to the first submount (11).

3. The laser diode device (1b) according to any of claims 1 and 2, wherein the laser diode (10) is a combination of at least one selected from the group consisting of a distributed feedback (DFB) laser, an electro-absorption modulated laser (EML), a Fabry-Perot (FP) laser, a distributed Bragg reflector (DBR), and a quantum dot (QD) laser.

4. The laser diode device (1b) according to any of claims 1-3, wherein the bump (14) is a stud bump (140), the stud bump (140) has a first diameter (d1) at a side of the stud bump (140) adjacent to the laser diode (10), the stud bump (140) has a second diameter (d1') at a side of the stud bump (140) adjacent to the second submount (12), and a ratio of the first diameter (d1) over the second diameter (d1') is between 0.9 and 1.1.

5. The laser diode device (1b) according to any of claims 1-3, wherein the bump (14) is a stud bump (140), the stud bump (140) has a first diameter (d1) at a side of the stud bump (140) adjacent to the laser diode (10), the stud bump (140) has the height (H1) extending from the laser diode (10) toward the second submount (12), and a ratio of the first diameter (d1) over the height (H1) of the stud bump (140) is between 0.85 and 1.1.

6. The laser diode device (1b) according to any of claims 4 and 5, wherein the laser diode device (1b) comprises a plurality of the stud bumps (140), the stud bumps (140) are adjacent to the waveguide (102) and distributed on a side of the laser diode (10) adjacent to the second submount (12), and a ratio of a sum of bottom areas of the stud bumps (140) over a surface area of the laser diode (10) is between 0.02 and 0.30.

7. The laser diode device (1b) according to any of claims 1-3, wherein a receiving space (V) is between the first submount (11), the laser diode (10), and the second submount (12), and the receiving space (V) is filled with a filling material (15), wherein the filling material (15) comprises an insulating base (150) and a plurality of conductive particles (152), the conductive particles (152) are distributed over the insulating base (150), and parts of the conductive particles (152) are between the bump (14) and the second submount (12).

8. The laser diode device (1b) according to any of claims 1-3, wherein:

    a receiving space (V) is between the first submount (11), the laser diode (10), and the second submount (12);
    the first submount (11) further comprises:

        a first submount body (110); and
        a first connection layer (114) on the first submount body (110), wherein a first end of the first connection layer (114) is electrically connected to the laser diode (10) in the receiving space (V), and a second end of the first connection layer (114) is electrically connected to the first electrode (116); and

    the second submount (12) further comprises:

a second submount body (120); and

a second connection layer (122) on a side of the second submount body (120) adjacent to the laser diode (10), wherein a first end of the second connection layer (122) is electrically connected to the bump (14); and

a via (124) in the second submount body (120), wherein a first end of the via (124) is electrically connected to a second end of the second connection layer (122), and a second end of the via (124) is electrically connected to the second electrode (128).

9. The laser diode device (1b) according to any of claims 1-3, wherein the bump (14) is a second submount protrusion (142), wherein the second submount protrusion (142) extends from the second submount (12) to allow the laser diode (10) to be electrically connected to the second electrode (128) through the second submount protrusion (142).

10. The laser diode device (1b) according to any of claims 1-3, wherein the bump (14) is a conductive paste (144) on a side of the laser diode (10) adjacent to the second submount (12), and a material of the conductive paste (144) is silver, tin, or an alloy of silver and tin.

11. An optical transceiver system (2) comprising:

an optical fiber (24);
a lens (22) adjacent to the optical fiber (24); and
a laser diode device (1b) comprising:

a first submount (11) comprising a first electrode (116);
a laser diode (10) on the first submount (11), wherein the laser diode (10) has a waveguide (102) on a side of the laser diode (10) away from the first submount (11);
a second submount (12) corresponding to the laser diode (10), wherein the second submount (12) comprises a second electrode (128); and
a bump (14) corresponding to the waveguide (102), wherein a height (H1) of the bump (14) is substantially higher than a height (H2) of the waveguide (102);
wherein a side of the laser diode (10) adjacent to the first submount (11) is electrically connected to the first electrode (116), one of two ends of the bump (14) is electrically connected to the second electrode (128), and the laser diode (10) is communicatively connected to the lens (22) and the optical fiber (24) through a light source.

12. The optical transceiver system (2) according to claim 11, further comprising a laser diode driver (20) electrically connected to the laser diode device (1b), wherein the laser diode driver (20) emits a driving signal to the laser diode device (1b) to allow the laser diode (10) of the laser diode device (1b) to be communicatively connected to the lens (22) and the optical fiber (24) through the light source.

13. The optical transceiver system (2) according to any of claims 11 and 12, wherein:
the bump (14) is a stud bump (140), the stud bump (140) has a first diameter (d1) at a side of the stud bump (140) adjacent to the laser diode (10), the stud bump (140) has the height (H1) extending from the laser diode (10) toward the second submount (12), and a ratio of the first diameter (d1) over the height (H1) of the stud bump (140) is between 0.85 and 1.1.

14. The optical transceiver system (2) according to any of claims 11 and 12, wherein a receiving space (V) is between the first submount (11), the laser diode (10), and the second submount (12), the receiving space (V) is filled with a filling material (15), the filling material (15) comprises an insulating base (150) and a plurality of conductive particles (152), the conductive particles (152) are distributed over the insulating base (150), and parts of the conductive particles (152) are between the bump (14) and the second submount (12).

15. The optical transceiver system (2) according to any of claims 11 and 12, wherein:

the bump (14) is a second submount protrusion (142), wherein the second submount protrusion (142) extends from the second submount (12) to allow the laser diode (10) to be electrically connected to the second electrode (128) through the second submount protrusion (142); or
the bump (14) is a conductive paste (144) on a side of the laser diode (10) adjacent to the second submount (12).

FIG. 1A

A-A'

FIG. 1B

FIG. 2A

FIG. 2B

FIG. 3A

EP 4 468 538 A1

FIG. 3B

EP 4 468 538 A1

EP 4 468 538 A1

FIG. 4

FIG. 5

FIG. 6A

EP 4 468 538 A1

FIG. 6B

**FIG. 7**

EP 4 468 538 A1

EP 4 468 538 A1

FIG. 8

FIG. 9

EP 4 468 538 A1

EP 4 468 538 A1

FIG. 10

FIG. 11

EP 4 468 538 A1

FIG. 12

Europäisches
Patentamt

European
Patent Office

Office européen
des brevets

# EUROPEAN SEARCH REPORT

Application Number

EP 24 15 0059

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/055670 A1 (INOUE YUTAKA [JP] ET AL) 26 February 2015 (2015-02-26) * paragraphs [0060] - [0063]; figure 5 * ----- | 1-15 | INV. H01S5/023 H01S5/02345 H01S5/0234 H01S5/0237 H01S5/024 |
| X | US 2011/116526 A1 (SORIMACHI SUSUMU [JP] ET AL) 19 May 2011 (2011-05-19) * paragraphs [0050] - [0073]; figure 1 * ----- | 1-15 | |
| A | US 2022/013980 A1 (KÖNIG HARALD [DE] ET AL) 13 January 2022 (2022-01-13) * paragraphs [0016] - [0030], [0086] - [0091]; figures 1A,1B * ----- | 1 | |
| A | US 5 615 224 A (COHEN DANIEL A [US]) 25 March 1997 (1997-03-25) * column 9, lines 3-32; figures 11a,11b * ----- | 1,11 | |

TECHNICAL FIELDS
SEARCHED        (IPC)

H01S

The present search report has been drawn up for all claims

| Place of search | Date of completion of the search | Examiner |
|---|---|---|
| Munich | 28 June 2024 | Riechel, Stefan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
.......................................................................
& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 24 15 0059

This annex lists the patent family members relating to the patent documents cited in the above-mentioned European search report.
The members are as contained in the European Patent Office EDP file on
The European Patent Office is in no way liable for these particulars which are merely given for the purpose of information.

28-06-2024

| Patent document cited in search report | | Publication date | Patent family member(s) | | Publication date |
|---|---|---|---|---|---|
| US 2015055670 | A1 | 26-02-2015 | JP | 5959484 B2 | 02-08-2016 |
| | | | JP | 2015041730 A | 02-03-2015 |
| | | | US | 2015055670 A1 | 26-02-2015 |
| US 2011116526 | A1 | 19-05-2011 | JP | 5465514 B2 | 09-04-2014 |
| | | | JP | 2011108932 A | 02-06-2011 |
| | | | US | 2011116526 A1 | 19-05-2011 |
| US 2022013980 | A1 | 13-01-2022 | DE | 102018130540 A1 | 04-06-2020 |
| | | | DE | 112019005944 A5 | 12-08-2021 |
| | | | US | 2022013980 A1 | 13-01-2022 |
| | | | WO | 2020109051 A1 | 04-06-2020 |
| US 5615224 | A | 25-03-1997 | NONE | | |

EPO FORM P0459

For more details about this annex : see Official Journal of the European Patent Office, No. 12/82